# EUROPÄISCHE PATENTANMELDUNG

(11) **EP 4 665 096 A1**
(43) Veröffentlichungstag der Anmeldung: **17.12.2025**
(21) Anmeldenummer: 24181752.7
(22) Anmeldetag: 12.06.2024
(51) Int. Cl.: H05K 7/20, H01M 10/633

(54) **VERFAHREN UND VORRICHTUNG ZUR ENTWÄRMUNG EINES ELEKTRISCHEN SYSTEMS**

(71) Anmelder: Siemens Aktiengesellschaft, 80333 München (DE)
(72) Erfinder: Boschert, Stefan, 85579 Neubiberg (DE); Grundmann, Jörn, 91091 Großenseebach (DE); Stegmeier, Stefan, 81825 München (DE); Walbrecker-Baar, Christian, 85757 Karlsfeld (DE)
(74) Vertreter: Siemens Patent Attorneys

(57) **Zusammenfassung**

Vorgeschlagen wird ein Verfahren und eine Vorrichtung zur Entwärmung eines elektrischen Systems umfassend ein Erfassen einer zeitlichen Vorhersage eines Lastprofils, eine Berechnung einer benötigten Kühlleistung, und eine Anpassung der Kapazität eines Kühlungssystems mittels Ansteuerung dessen Anbindungskomponenten zu weiteren Kühlungssystemen, auf Basis der berechneten benötigten Kühlleistung. Die beschriebene innovative Lösung gestaltet den Wärmefluss von einer Hitzequelle zum Kühler effizienter und berücksichtigt gleichzeitig eine zeitliche Vorhersage der Anwendung, wie beispielsweise eines Lastprofils. Dies wird durch eine Wechselwirkung zwischen Kühlsystemen ermöglicht.

## Beschreibung

Die vorliegende Erfindung betrifft ein Verfahren zur Entwärmung eines elektrischen Systems sowie eine Vorrichtung dazu.

### Stand der Technik

Die Leistungsfähigkeit und Lebensdauer elektronischer Bauelemente wie MOSFETs und IGBTs, elektrischen Maschinen wie beispielsweise Motoren oder Katalysatoren, in denen chemischer Prozesse ablaufen, hängen maßgeblich von ihrer Entwärmung ab bzw. den Temperaturen, denen sie ausgesetzt sind. Der Wärmefluss von der Hitzequelle zum Kühler muss oft über verschiedene Barrieren wie Bodenplatten, Substrate und thermische Interface-Materialien geleitet werden. Neben der Abkühlungseffektivität spielt auch die Abkühlungseffizienz eine wichtige Rolle. Die Zeit, die für die notwendige Entwärmung benötigt wird, bestimmt die Kühlungsart. Hohe Wärmeströme werden in der Regel durch Flüssigkeitskühlung bewältigt, während geringe Wärmeströme durch Luftkühlung ausreichend abtransportiert werden können.

Die Implementierung der Kühlung ist jedoch je nach Anwendung sehr aufwendig. Eine effektive Kühlung im Bereich elektronischer Bauelement, insbesondere im Bereich der Leistungselektronik, erfordert den Einsatz kostspieliger wärmeleitender Keramiken wie Aluminiumnitrid als Isolationsschichten. Die Verwendung aufwändig hergestellter Kühler sowie das Einbringen von Wärmespreizplatten beeinfluss die Größe und den Herstellungsprozess. Dies führt zu hohen Kosten aufgrund der Vielzahl unterschiedlicher Komponenten und Materialien. Insbesondere der Einsatz von Metall in großen Mengen und die Herstellungsverfahren, z.B. das Einpressen von Kühllamellen in stranggepresste Kühler erhöhen technischen Aufwand und Kosten.

Elektrische Systeme, insbesondere elektrische Maschinen, elektronische Anlagen sowie deren Anwendungsprozesse sind oft statisch ausgelegt. Das heißt, sie sind so optimiert, dass sie auch noch im extremsten Temperaturereignisfall ausreichend gekühlt werden können. Dadurch werden Ressourcen oft verschwendet, da die Kühler insbesondere bei stark dynamischem Betrieb für die meiste Zeit überdimensioniert sind.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung trotz Ressourcenschonung Hochtemperatursituationen bewältigen können.

Diese Aufgabe wird durch die Merkmale des unabhängigen Patentanspruchs 1 sowie durch die Merkmale des Patentanspruchs 7 gelöst. Vorteilhafte Ausgestaltungen der Erfindung sind Gegenstand der Unteransprüche.

### Beschreibung der Erfindung

Das erfindungsgemäße Verfahren zur Entwärmung eines elektrischen Systems umfasst eine Erfassung einer zeitlichen Vorhersage eines Lastprofils, eine Berechnung einer benötigten Kühlleistung, und eine Anpassung der Kapazität eines Kühlungssystems mittels Ansteuerung dessen Anbindungskomponenten zu weiteren Kühlungssystemen, auf Basis der berechneten benötigten Kühlleistung.

Dabei ist unter einem elektrischen System, insbesondere ein elektronisches System, ein elektrisches oder elektronisches Bauteil, ein elektronische Komponente oder Bauelement zu verstehen.

Unter einem Lastprofil ist im Kontext der Anmeldung eine Beschreibung des Verhaltens eines elektrischen Geräts oder einer elektrischen Last in Bezug auf den Stromverbrauch zu verstehen. Das Lastprofil zeigt typischerweise die Variation des Stromverbrauchs in Abhängigkeit von der Zeit, wobei verschiedene Betriebszustände und Laständerungen berücksichtigt werden. Messwerte für Lastprofile können auf verschiedene Weise erfasst werden, zum Beispiel durch Messungen an realen Geräten, durch Simulationen oder anhand von statistischen Daten. Eine manuelle Eingabe ist auch möglich.

Zur Berechnung der benötigten Kühlleistung: Aus Berechnungen und Modellen in der Entwicklungsphase des Produktes können Anhand der Lastmessung berechnet werden, wie hoch die Kühlleistung sein muss. Zur Wärmeentwicklung im elektrischen System trägt zunächst die intrinsische Wärmeentwicklung bei: Strom erzeugt Wärme durch thermische Widerstände im System. Hinzu kommen Umgebungsbedingungen. Diese Wärme muss aus dem System abtransportiert werden. Die Kühlleistung wird erbracht von verschiedenen Kühlern. Als Variable für die Berechnung kann beispielsweise eine Durchflussmenge eines Kühlmittels, entsprechend dem Wärmeabfluss, oder die Temperatur im einfacheren Fall herangezogen werden.

Bei einer Vorhersage wird die Berechnung komplexer. Hier können verschiedene Parameter berücksichtigt werden. Insbesondere basiert eine Vorhersage auf einer Musterhistorie, welche auf ein zukünftiges Profil schließen lässt. Es werden Betriebszeiten, Stoßlasten, Umweltmuster, wie Sonnenstand und Schattenwurf, sowie Jahreszeiten berücksichtigt. Dies wird bevorzugt mittels einer KI-basierte Mustererkennung (KI für künstliche Intelligenz) realisiert.

Dieses vorgeschlagene Verfahren hat den Vorteil, dass in der Kühlungsstrategie eine zeitliche Reaktion auf bevorstehende Lastfälle berücksichtigt wird.

Zum Beispiel könnte die Windstärke in einer Stunde stark ansteigen, was dazu führt, dass eine Mittelspannungsschaltanlage einer Windkraftanlage deutlich höhere Ströme schalten muss und die Leistungselektronik stärker gekühlt werden muss.

In einer vorteilhaften Variante des erfindungsgemäßen Verfahrens ist des Weiteren eine Berechnung eines zeitlichen Verlaufs der benötigten Kühlleistung, und eine dynamische Anpassung der Kapazität des Kühlungssystems mittels Ansteuerung dessen Anbindungskomponenten zu weiteren Kühlungssystemen, auf Basis des berechneten zeitlichen Verlaufs der benötigten Kühlleistung vorgesehen.

Dadurch wird das Kühlkonzept noch ressourcenschonender ausgelegt, da nicht nur die rechtzeitige Erhöhung der Kühlkapazität, sondern auch das zeitlich vorherplanbare Absenken der Kühlleistung realisierbar ist.

In einer weiteren Ausführungsform einer der vorstehend beschriebenen Varianten des erfindungsgemäßen Verfahrens, erfolgt eine Anpassung der Kapazität des Kühlungssystems mittels Ansteuerung wenigstens einer Heatpipe, welche das Kühlsystem an wenigstens eine weitere Kühlkomponenten oder ein weiteres Kühlsystem anbindet.

Alternativ oder zusätzlich erfolgt eine Anpassung der Kapazität des Kühlungssystems mittels Ansteuerung wenigstens einer Kühlmittelleitung, welche das Kühlsystem an wenigstens eine weitere Kühlkomponenten oder ein weiteres Kühlsystem anbindet. Dazu ist insbesondere eine Ansteuerung wenigstens einer Kühlmittelpumpe vorgesehen.

Diese Ausführungsformen mit einem Flüssigkeitskühlungskonzept haben insbesondere den Vorteil, mit bewährten Technologien umgesetzt werden zu können. Bei der Maximalauslegung wird bevorzugt darauf geachtet, die Kombinierbarkeit mit weiteren Kühlsystemen derart zu gestalteten, dass Temperaturpeaks anwendungsbedingt nicht in allen Systemen gleichzeitig auftreten.

In einer weiteren Ausführungsform einer der vorstehend beschriebenen Varianten des erfindungsgemäßen Verfahrens, erfolgt eine Anpassung der Kapazität des Kühlungssystems mittels Ansteuerung wenigstens eines Luftkühlers erfolgt, dessen Wirkungsradius mittels der Steuereinheit adaptierbar ist.

Dies hat den Vorteil sehr einfach baulich umsetzbar zu sein. Insbesondere werden die in bisherigen elektrischen Systemen eingesetzten Luftkühler einfach kleiner ausgelegt, da sie dann im Temperaturereignisfall unterstützend zusammengeschlossen werden können. Luftkühler können auch mittels beweglicher Anordnung in ihrem Wirkungsradius adaptierbar gestaltet werden.

Die erfindungsgemäße Vorrichtung zur Entwärmung eines elektrischen Systems weist zunächst eine Steuereinheit auf, welche zum Erfassen einer zeitlichen Vorhersage eines Lastprofils ausgestaltet ist, außerdem eine Recheneinheit, die zur Berechnung einer benötigten Kühlleistung ausgestaltet ist, und ein Kühlungssystem mit ansteuerbaren Anbindungskomponenten zu weiteren Kühlkomponenten oder Kühlungssystemen, wobei die Steuereinheit des Weiteren ausgestaltet ist, auf Basis der berechneten benötigten Kühlleistung mittels Ansteuerung der Anbindungskomponenten wenigstens eine weitere Kühlkomponente mit dem Kühlungssystem zu verbinden oder davon zu trennen und so die Kapazität des Kühlungssystems anzupassen.

Damit ist die Vorrichtung geeignet ein elektrisches System, insbesondere ein elektronisches System, ein elektrisches oder elektronisches Bauteil, ein elektronische Komponente oder Bauelement zu entwärmen. Die Vorrichtung kann dazu ein Interface umfassen. Die Steuerung kann eine autarke Einheit sein, aber auch Teil einer vorhanden Einheit, insbesondere als Softwarekomponente, beispielsweise als Teil einer SPS- Steuerung oder eines PCs oder einem beliebigen softwarefähigem elektronischen Endgerät.

Eine SPS-Steuerung (Speicherprogrammierbare Steuerung) ist eine spezielle Art von Steuerungssystem, das in der Industrie zur Automatisierung von Maschinen und Anlagen eingesetzt wird. Sie besteht aus einer zentralen Steuereinheit, die über digitale und analoge Ein- und Ausgänge mit verschiedenen Sensoren, Aktoren und anderen Komponenten verbunden ist. Die SPS-Steuerung arbeitet nach einem vorher programmierten Ablaufplan, der in einem Speicher abgespeichert ist. Dieser Ablaufplan, auch als Steuerungsprogramm bezeichnet, legt fest, wie die Steuerung auf bestimmte Eingangssignale reagiert und welche Ausgangssignale sie entsprechend generiert. Das Programm kann durch den Anwender angepasst oder erweitert werden, um die gewünschte Funktionalität zu erreichen. SPS-Steuerungen sind in der Regel sehr robust und zuverlässig, da sie für den Einsatz in industriellen Umgebungen entwickelt wurden. Sie werden in verschiedenen Bereichen eingesetzt, wie beispielsweise in der Fertigungsindustrie, der Automobilindustrie, der Gebäudeautomatisierung und der Prozesssteuerung. Durch ihre Flexibilität, Programmierbarkeit und einfache Bedienung bieten SPS-Steuerungen eine effiziente Möglichkeit zur Automatisierung von Maschinen und Anlagen, wodurch Produktionsprozesse optimiert und automatisierte Abläufe realisiert werden können.

Unter einem PCs oder einem beliebigen softwarefähigem elektronischen Endgerät ist ein elektronisches Gerät zu verstehen, das konzipiert ist für eine Vielzahl von Aufgaben und aus einer Kombination von Hardwarekomponenten wie Prozessor, Speicher und Grafikkarte sowie Softwarekomponenten besteht. Abhängig von eben der Software können derartige Geräte komplexe Berechnungen, Datenverarbeitung und spezialisierte Anwendungen vornehmen. Die Leistungsfähigkeit des Endgeräts wird durch Faktoren wie Prozessorgeschwindigkeit, Arbeitsspeicher und Grafikleistung bestimmt. Ein Betriebssystem ermöglicht die Steuerung der Hardware und stellt bevorzugt dem Benutzer eine Benutzeroberfläche zur Verfügung.

In einer vorteilhaften Ausführungsform der erfindungsgemäßen Vorrichtung, ist die Recheneinheit des Weiteren ausgestaltet, einen zeitlichen Verlauf der benötigten Kühlleistung zu berechnen, und die Steuereinheit ist ausgestaltet, die Kapazität des Kühlungssystems mittels Ansteuerung dessen Anbindungskomponenten zu weiteren Kühlungssystemen, auf Basis des berechneten zeitlichen Verlaufs der benötigten Kühlleistung dynamisch anzupassen.

Diese vorgeschlagene Vorrichtung hat den Vorteil, dass das Kühlungssystem nicht nur zeitlich auf bevorstehende Temperaturlastfälle vorbereitet wird, sondern der gesamte zeitliche Temperaturverlauf berücksichtigt wird und somit insbesondere im Fall aktiver Kühlung Energie eingespart werden kann.

In einer weitere vorteilhaften Ausführungsform der vorstehend beschriebenen erfindungsgemäßen Vorrichtungsvarianten, weist die Vorrichtung wenigstens eine Heatpipe auf, welche mittels der Steuereinheit schaltbar ist und als Anbindungskomponente zu Kühlkomponenten oder Kühlsystemen ausgestaltet ist.

In einer weitere vorteilhaften Ausführungsform der vorstehend beschriebenen erfindungsgemäßen Vorrichtungsvarianten, ist wenigstens eine Kühlmittelleitung umfasst, welche mittels der Steuereinheit schaltbar ist und als Anbindungskomponente zu Kühlkomponenten oder Kühlsystemen ausgestaltet ist.

Unter einer schaltbaren Kühlmittelleitung ist beispielsweise eine Kühlmittelleitung zu verstehen, welche schaltbare Klappen und/oder Ventile umfasst.

Alternativ oder zusätzlich kann in einer Ausführungsform einer der vorstehend beschriebenen erfindungsgemäßen Vorrichtungsvarianten wenigstens eine Kühlmittelpumpe vorgesehen sein, welche mittels der Steuereinheit schaltbar ist.

Diese Ausgestaltungen haben insbesondere den Vorteil, dass Wärmekapazitäten werden sehr flexibel und energieeffizient hin und her gepumpt werden. Die Kühlmittelpumpe greift dazu beispielsweise auch in die Kühlmitteltransportgeschwindigkeit ein.

In einer weitere vorteilhaften Ausführungsform der vorstehend beschriebenen erfindungsgemäßen Vorrichtungsvarianten, ist wenigstens ein Luftkühler vorgesehen, dessen Wirkungsradius mittels der Steuereinheit adaptierbar ist.

Diese Adaptierbarkeit des Wirkungsradius kann insbesondere dadurch realisiert sein, der Luftkühler im Abstand veränderbare Lamellen aufweist.

Alternativ oder zusätzlich weist der wenigstens eine Luftkühler im Winkel veränderbare Lamellen auf.

Alternativ oder zusätzlich ist der wenigstens eine Luftkühler schwenkbar angeordnet.

Dies hat den Vorteil sehr einfach baulich umsetzbar zu sein. Insbesondere kann diese vorgeschlagene Lösung leicht in elektrischen Systemen eingesetzt werden, die aktuell bereits mit Luftkühlern ausgestaltet sind. Bevorzugt können die Luftkühler dann aber kleiner ausgelegt werden, da sie im Temperaturereignisfall unterstützend zusammengeschlossen werden können. Luftkühler können auch mittels beweglicher Anordnung der Kühler selbst aber auch der Lamellen in ihrem Wirkungsradius adaptierbar gestaltet werden.

Weitere Merkmale, Eigenschaften und Vorteile der vorliegenden Erfindung ergeben sich aus der nachfolgenden Beschreibung unter Bezugnahme auf die beiliegende Figuren. Darin zeigen schematisch:
Figur 1 eine schematische Seitenansicht eines elektrischen Systems 10 mit elektronischen Bauelementen 11, welche mittels wärmeleitfähiger Anbindung 12 entwärmt werden können,
Figur 2eine schematische Draufsicht auf eine steuerbare Kühlmittelleitung 13 und

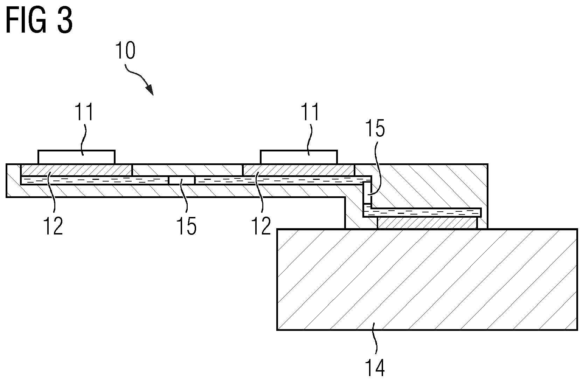

Figur 3eine schematische Seitenansicht eines elektrischen Systems 10 mit elektronischen Bauelementen 11, welche mittels eines steuerbarem Kühlsystems entwärmt werden können.

Die vorgeschlagene Lösung stellt ein innovatives dynamisches Kühlshift-Konzept dar. Dieses effektive Kühlkonzept besteht insbesondere aus drei Schritten, mittels derer eine optimierte Kühlung realisiert wird.

Als erster Schritt wird eine zeitliche Vorhersage des Lastprofils des zu entwärmenden elektrischen Systems 10 genutzt. Dadurch stehen Informationen zur Verfügung, wann und in welchem Umfang ein Lastanstieg und dementsprechend ein Temperaturanstieg im System 10 und insbesondere lokal an verschiedenen Komponenten 11 des Systems 10 zu erwarten ist.

Auf Grundlage dieser Vorhersage wird im zweiten Schritt die erforderliche Kühlleistung berechnet.

Im dritten Schritt werden zusätzliche Kühlleistungen von anderen Systemen im Voraus oder parallel zum betroffenen lokalen System 12 hinzugeschaltet. Dies hat zur Folge, dass die maximale Temperatur der Wärmequelle 11 im Lastfall reduziert wird.

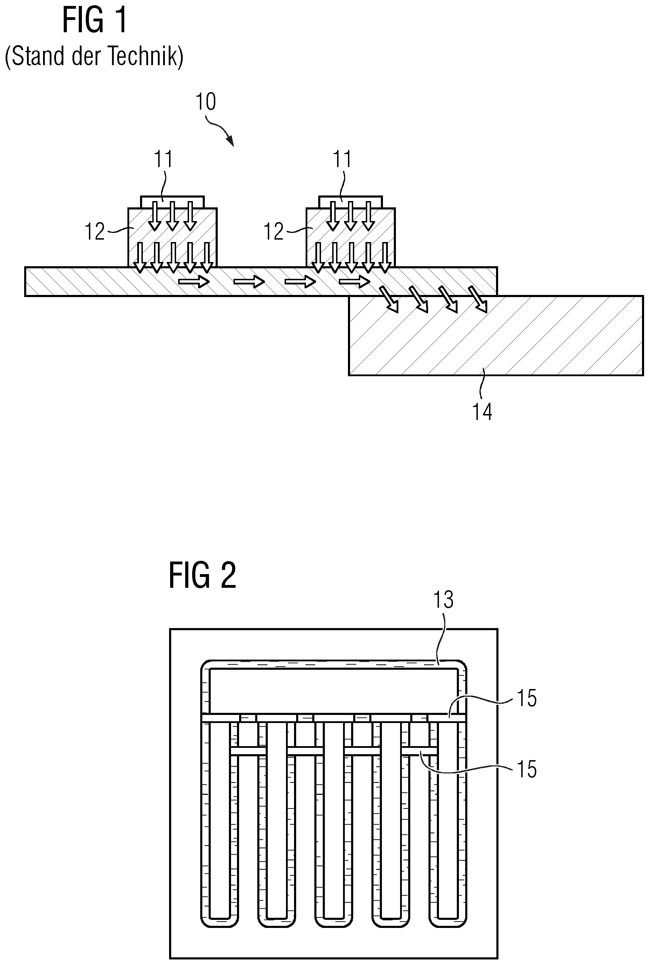

Die zeitliche Komponente spielt hierbei eine entscheidende Rolle. Beispielsweise umfasst ein System 10 Kühler 12,14, Bodenplatte, Substrate und Gehäuse. Das Wärmemanagement eines Systems 10, wird dann so gesteuert, dass der thermische Pfad, durch Pfeile in Figur 1 dargestellt, ideal angepasst werden kann. Das bedeutet, dass im Lastfall eine möglichst effiziente Entwärmung der Wärmequelle 11 stattfindet.

Es gibt verschiedene Möglichkeiten, um zusätzliche Kühlleistung von anderen Teilkühlsystemen 12 zu erhalten. Eine Option besteht darin, Kühler 12 durch schaltbare Heatpipes oder Kühlmittelleitungen 13 miteinander zu verbinden. Eine weitere Möglichkeit ist die Verbindung der Kühler 12 über wärmeübertragende Fluide wie Wasser, dielektrische synthetische Ester oder Thermoöle. Zudem kann die Wärme von verschiedenen Systemen hin und her gepumpt werden, 15, um große Wärmekapazitäten zu schaffen.

Des Weiteren können Luftkühler durch Anpassung des Abstands und der Lamellen so modifiziert werden, dass sie die Kühlung benachbarter Systeme unterstützen können. Eine weitere Option ist die Installation mehrerer beweglicher Kühler, die geschwenkt und bewegt werden können. Zusätzlich kann Luft oder ein Fluid durch Klappen 15 umgelenkt werden, um die Kühlleistung zu optimieren.

Eine beispielhafte Anwendung könnte im Bereich der Warenkühlung erfolgen. Ein erstes Kühlsystem ist für Waren vorgesehen, auf die häufig zugegriffen werden muss. Dieses Kühlsystem begegnet den Herausforderungen, dass durch den häufigen Zugriff eine entsprechend hohe Wärmelast entsteht.

Dieses erste Kühlsystem steht in gesteuerter Fluidkommunikation, beispielsweise Luftaustausch mit einem zweiten Kühlsystem für Waren, auf die sehr selten zugegriffen werden muss. Damit kann das Kälteaggregat des zweiten Kühlsystems für das erste Kühlsystem mit genutzt werden. Die Luft ist dabei beispielsweise der Vermittler.

Die stärkere Ausnutzung der Kältemaschine des zweiten Kühlsystems, als es für dieses Kühlsystem allein nötig wäre, bringt die "richtige" gemittelte Temperatur für beide Kühlsysteme näher, wenn der Luftaustausch entsprechend gesteuert wird. Und das erfolgt mit jeweils kleiner dimensionierten Kälteanlagen.

Die vorliegende Erfindungsmeldung bietet eine Reihe von Vorteilen:
Erstens ermöglicht sie eine effiziente Entwärmung von Systemen 10 basierend auf dem Lastprofil. Dadurch wird gewährleistet, dass die Kühlung den Anforderungen entsprechend angepasst wird und die Wärmequelle 11 optimal entwärmt wird.
Zweitens trägt sie zur Erhöhung der Systemlebensdauer bei, indem sie die maximale Hotspot-Temperatur verringert. Dies reduziert die Belastung der Komponenten 11 und verhindert mögliche Schäden durch Überhitzung.
Drittens führt sie zu einer Steigerung des Wirkungsgrades des Systems 10, da niedrigere Temperaturen erreicht werden. Dies ermöglicht eine effizientere Nutzung der Systeme 10 und trägt zur Energieeinsparung bei.
Viertens kann sie zu erheblichen Kosteneinsparungen führen, da das System 10 eine längere Lebensdauer hat. Dadurch wird vermieden, dass das System 10 vorzeitig ausgetauscht werden muss, was mit zusätzlichen Kosten verbunden wäre.
Fünftens führt sie zu einer Materialeinsparung, da nicht mehr so viel Kühlredundanz verbaut werden muss. Dies reduziert den Einsatz von Materialien und trägt zur Nachhaltigkeit bei. Insgesamt bietet die vorgeschlagene Lösung eine Reihe von Vorteilen, die eine effiziente Entwärmung, eine längere Systemlebensdauer, einen höheren Wirkungsgrad, Kosteneinsparungen und eine Materialeinsparung ermöglichen.

Obwohl die Erfindung im Detail durch das Ausführungsbeispiel näher illustriert und beschrieben wurde, ist die Erfindung nicht durch offenbarte Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste

- 10: elektrisches System
- 11: elektronisches Bauelement, zu entwärmende Komponente
- 12: wärmeleitfähiger Anbindung, lokale Kühlkomponente, Teilkühlsystem, beispielsweise Kühlkörper
- 13: steuerbare Kühlmittelleitung, steuerbares Kühlsystem
- 14: Kühlkomponente zur Wärmeabfuhr an die Systemumgebung
- 15: steuerbare Anbindungskomponenten, insbesondere steuerbare Klappen, Ventile und/oder Pumpen im Kühlsystem, zum Beispiel in der Kühlmittelleitung

Zusammenfassend wird also festgehalten, dass die vorstehend beschriebene innovative Lösung, den Wärmefluss von einer Hitzequelle 11 zum Kühler 14 effizienter gestaltet und gleichzeitig eine zeitliche Vorhersage der Anwendung, wie beispielsweise eines Lastprofils, berücksichtigt. Dies wird durch eine Wechselwirkung zwischen verschalteten Kühlsystemen 12 ermöglicht.

## Patentansprüche

1. Verfahren zur Entwärmung eines elektrischen Systems (10) umfassend,
Erfassen einer zeitlichen Vorhersage eines Lastprofils,
Berechnung einer benötigten Kühlleistung, und
Anpassung der Kapazität eines Kühlungssystems (12, 13) mittels Ansteuerung dessen Anbindungskomponenten (15) zu weiteren Kühlungssystemen, auf Basis der berechneten benötigten Kühlleistung.

2. Verfahren nach Anspruch 1, des Weiteren umfassend,
Berechnung eines zeitlichen Verlaufs der benötigten Kühlleistung, und
dynamische Anpassung der Kapazität des Kühlungssystems (12, 13) mittels Ansteuerung dessen Anbindungskomponenten (15) zu weiteren Kühlungssystemen, auf Basis des berechneten zeitlichen Verlaufs der benötigten Kühlleistung.

3. Verfahren nach Anspruch 1 oder 2, wobei die Anpassung der Kapazität des Kühlungssystems (12, 13) mittels Ansteuerung wenigstens einer Heatpipe erfolgt, welche das Kühlsystem an wenigstens eine weitere Kühlkomponenten oder ein weiteres Kühlsystem anbindet.

4. Verfahren nach einem der vorstehenden Ansprüche, wobei die Anpassung der Kapazität des Kühlungssystems (12, 13) mittels Ansteuerung wenigstens einer Kühlmittelleitung erfolgt, welche das Kühlsystem an wenigstens eine weitere Kühlkomponenten oder ein weiteres Kühlsystem anbindet.

5. Verfahren nach vorstehendem Anspruch 4, umfassend eine Ansteuerung wenigstens einer Kühlmittelpumpe .

6. Verfahren nach einem der vorstehenden Ansprüche, wobei die Anpassung der Kapazität des Kühlungssystems (12, 13) mittels Ansteuerung wenigstens eines Luftkühlers erfolgt, dessen Wirkungsradius mittels der Steuereinheit adaptierbar ist.

7. Vorrichtung zur Entwärmung eines elektrischen Systems (10) aufweisend,
eine Steuereinheit, welche zum Erfassen einer zeitlichen Vorhersage eines Lastprofils ausgestaltet ist,
eine Recheneinheit, ausgestaltet zur Berechnung einer benötigten Kühlleistung,
ein Kühlungssystem (12, 13) mit ansteuerbaren Anbindungskomponenten (15) zu weiteren Kühlkomponenten oder Kühlungssystemen,
wobei die Steuereinheit des Weiteren ausgestaltet ist, auf Basis der berechneten benötigten Kühlleistung mittels Ansteuerung der Anbindungskomponenten wenigstens eine weitere Kühlkomponente mit dem Kühlungssystem (12, 13) zu verbinden oder davon zu trennen und so die Kapazität des Kühlungssystems (12, 13) anzupassen.

8. Vorrichtung nach Anspruch 7, wobei die Recheneinheit des Weiteren ausgestaltet ist, einen zeitlichen Verlauf der benötigten Kühlleistung zu berechnen, und die Steuereinheit ausgestaltet ist, die Kapazität des Kühlungssystems (12, 13) mittels Ansteuerung dessen Anbindungskomponenten zu weiteren Kühlungssystemen, auf Basis des berechneten zeitlichen Verlaufs der benötigten Kühlleistung dynamisch anzupassen.

9. Vorrichtung nach einem der Ansprüche 7 oder 8, aufweisend wenigstens eine Heatpipe, welche mittels der Steuereinheit schaltbar ist und als Anbindungskomponente (15) zu Kühlkomponenten oder Kühlsystemen ausgestaltet ist.

10. Vorrichtung nach einem der Ansprüche 7 bis 9, aufweisend wenigstens eine Kühlmittelleitung, welche mittels der Steuereinheit schaltbar ist und als Anbindungskomponente (15) zu Kühlkomponenten oder Kühlsystemen ausgestaltet ist.

11. Vorrichtung nach Anspruch 10, aufweisend wenigstens eine Kühlmittelpumpe, welche mittels der Steuereinheit schaltbar ist.

12. Vorrichtung nach einem der Ansprüche 7 bis 11, aufweisend wenigstens einen Luftkühler, dessen Wirkungsradius mittels der Steuereinheit adaptierbar ist.

13. Vorrichtung nach Anspruch 12, wobei der wenigstens eine Luftkühler im Abstand veränderbare Lamellen aufweist.

14. Vorrichtung nach einem der Ansprüche 12 oder 13, wobei der wenigstens eine Luftkühler im Winkel veränderbare Lamellen aufweist.

15. Vorrichtung nach einem der Ansprüche 12 bis 14, wobei der wenigstens eine Luftkühler schwenkbar ist.
